(19) Europäisches Patentamt
European Patent Office
Office européen des brevets

(11) **EP 3 730 958 B1**

(12) **EUROPÄISCHE PATENTSCHRIFT**

(45) Veröffentlichungstag und Bekanntmachung des Hinweises auf die Patenterteilung:
**10.05.2023  Patentblatt 2023/19**

(21) Anmeldenummer: **20165174.2**

(22) Anmeldetag: **24.03.2020**

(51) Internationale Patentklassifikation (IPC):
**G01R 31/392** (2019.01)   **G01R 31/00** (2006.01)
**G01R 31/382** (2019.01)

(52) Gemeinsame Patentklassifikation (CPC):
**G01R 31/392; G01R 31/006; G01R 31/382**

(54) **VERFAHREN ZUR BEWERTUNG DES GESUNDHEITSZUSTANDES EINER HOCHVOLTBATTERIE UND BATTERIETESTER**

METHOD FOR EVALUATING THE STATE OF HEALTH OF A HIGH-VOLTAGE BATTERY AND BATTERY TESTER

PROCÉDÉ D'ÉVALUATION DE L'ÉTAT DE SANTÉ D'UNE BATTERIE HAUTE TENSION ET TESTEUR DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.04.2019  DE 102019205843**

(43) Veröffentlichungstag der Anmeldung:
**28.10.2020  Patentblatt 2020/44**

(73) Patentinhaber: **Robert Bosch GmbH
70442 Stuttgart (DE)**

(72) Erfinder:
• **Schindler, Holger
73733 Esslingen (DE)**
• **Heintz, Benjamin
71638 Ludwigsburg (DE)**
• **Klissenbauer-Mathae, Matthias
73084 Salach (DE)**

(56) Entgegenhaltungen:
**EP-A1- 3 246 215       WO-A1-2015/101570
CN-A- 107 132 484    CN-B- 102 760 914
CN-B- 105 015 360    CN-B- 106 526 486
US-A1- 2007 029 974  US-A1- 2011 112 781
US-A1- 2018 188 332  US-B2- 10 005 372**

EP 3 730 958 B1

**Beschreibung**

Die vorliegende Erfindung betrifft ein Verfahren zur Bewertung des Gesundheitszustandes einer Hochvoltbatterie, sowie einen Batterietester. Insbesondere betrifft die vorliegende Erfindung die Bewertung einer Hochvoltbatterie eines Hybridfahrzeuges.

Stand der Technik

Die Druckschrift DE 10 2014 217 135 A1 offenbart ein Verfahren und eine Vorrichtung zur Bestimmung eines State-of-Health- und eines State-of-Charge-Wertes einer Batterie. Hierzu wird mindestens ein Impedanzwert der Batterie bei mindestens einer Frequenz, sowie eine Ausgangsgröße anhand des ermittelten Impedanzwertes ermittelt. Durch Vergleich der ermittelten Werte mit einem Präferenzwert wird daraufhin ein State-of-Health-Wert ermittelt.

Elektro- oder Hybridfahrzeuge werden ganz oder teilweise durch elektrische Energie angetrieben, die von einer Traktionsbatterie bereitgestellt wird. Um eine ausreichende Reichweite eines solchen Fahrzeuges gewährleisten zu können, ist es erforderlich, dass die dabei eingesetzte Traktionsbatterie eine ausreichende Speicherkapazität für die elektrische Energie aufweist. Mit zunehmender Alterung sinkt jedoch die Speicherkapazität der Traktionsbatterie. Daher sollte die Traktionsbatterie ausgetauscht werden, wenn die verfügbare Speicherkapazität nicht mehr ausreicht, um die geforderte Reichweite des Fahrzeugs zu gewährleisten.

Da an die Speicherkapazität der Traktionsbatterien von Elektro- und Hybridfahrzeugen sehr hohe Anforderungen gestellt werden, muss der Gesamt-Gesundheitszustand einer Batterie im Elektro-oder Hybridfahrzeug regelmäßig überprüft werden.

Das Dokument CN 105 015 360 B, zeigt ein SOF-Überwachungsverfahren für eine Fahrzeugbatterie. Das Dokument CN 107132484 A zeigt ein Testsystem für ein Batteriesystem. Das Dokument CN 106 526 486 B zeigt eine Methode zur Bestimmung des Alterungsgrades einer Lithiumbatterie. Die Dokumente US 10 005 372 B2, US 2018/188332 A1, WO 2015/101570 A1, CN 102 760 914 B, EP 3 246 215 A1 zeigen Methoden zur Bestimmung des Gesundheitszustandes einer Batterie.

Offenbarung der Erfindung

Die vorliegende Erfindung schafft ein Verfahren zur Bewertung des Gesundheitszustandes einer Hochvoltbatterie eines Hybridfahrzeugs im eingebauten Zustand in einem Fahrzeug gemäß dem unabhängigen Patentanspruch 1, sowie einen Batterietester gemäß dem unabhängigen Patentanspruch 4.

Vorteile der Erfindung

Das erfindungsgemäße Verfahren und der Batterietester mit den Merkmalen gemäß der unabhängigen Ansprüche hat den Vorteil, dass eine Aussage über den Gesamt-Gesundheitszustand einer Hochvoltbatterie eines Hybridfahrzeuges im eingebauten Zustand gemacht werden kann. Dies ermöglicht schon recht früh Aussagen darüber, ob die Hochvoltbatterie noch die Leistungsfähigkeit besitzt, um in einem Hybridfahrzeug eingesetzt werden zu können.

Ohne das erfinderische Verfahren und den erfinderischen Batterietester würde sich ein schlechter Gesamt-Gesundheitszustand einer Hochvoltbatterie erst durch einen erhöhten Kraftstoffverbrauch bemerkbar machen, welcher in den meisten Fällen unerwünscht ist.

Der erhöhte Kraftstoffverbrauch wird unter anderem durch gealterte Batterien verursacht, dies sorgt dafür, dass Kunden eines Hybridfahrzeugs sich entweder einen neuen Akkumulator kaufen müssen oder das alte Fahrzeug durch ein neues Fahrzeug ersetzen müssen. Die Problematik hierbei ist es, zu erkennen, wie hoch die Leistungsfähigkeit der Hochvoltbatterie noch ist, um präzisere Aussagen darüber treffen zu können, wann die Hochvoltbatterie getauscht werden sollte oder es allgemein zu Problemen kommen könnte. Ähnlich dem Verhalten einer Blei-Batterie im Winter, bei der die Leistung nicht ausreichend für einen Start des Motors ist, verhält sich dies auch bei einem Akkumulator. Bevor sich eine alternde Hochvoltbatterie an einen stetig steigenden Verbrauch am Kraftstoff bemerkbar macht, oder allgemein die Leistungsfähigkeit der Hochvolteinheit nicht mehr gegeben ist, möchte man in der Werkstatt schon frühzeitig erkennen, wie der "Fitnesszustand" eines im Elektro- oder Hybridfahrzeug befindlichen Ackumulators ist.

Im erfindungsgemäßen Verfahren wird die Hochvoltbatterie lediglich über den im Fahrzeug befindlichen Datenbus analysiert. Bei der Prüfung bleibt der zu vermessende Akkumulator im Fahrzeug eingebaut. Das Verfahren zur Bewertung des Gesamt-Gesundheitszustandes der Hochvoltbatterie besteht aus einem statischen und einem dynamischen Teil. Es wird ein "State of Health", eine Kapazität, Differenzspannungen und -innenwiderstände zwischen den Batteriezellen geprüft und diese Werte dann mit den Referenzwerten einer neuwertigen Hochvoltbatterie verglichen. Das Ergebnis des Verfahrens ermittelt den Gesamt-Gesundheitszustand der Hochvoltbatterie auf Basis der oben genannten Messwerte.

In den abhängigen Ansprüchen sind vorteilhafte Ausgestaltungen und Weiterbildungen der erfindungsgemäßen Vorrichtung und des erfindungsgemäßen Verfahrens angegeben.

Es ist von Vorteil, wenn die Differenzspannung, die Kapazität, die Leistung und der Innenwiderstand in die Bewertung des Gesamt-Gesundheitszustandes einfließen. Im Folgenden wird jeweilige Bedeutung für das Hybridfahrzeug erläutert.

Differenzspannung

Eine der wichtigen Erkenntnisse ist die Ermittlung der Differenzspannung zwischen den Batterieblöcken innerhalb der Hochvoltbatterie. Falls kein Balancing-System für die Angleichung der Spannungen der einzelnen Blöcke vorhanden ist, kann mit zunehmendem Alter eine Differenz der Blockspannungen entstehen, die im Hochvoltmodul eine ungleichmäßige Verteilung der Energie verursacht und somit die Performance herabgesetzt werden kann.

Kapazität

Die Ermittlung der vorhandenen Kapazität gibt Aufschluss über die Speicherfähigkeit der Hochvoltbatterie. Durch die Kapazität kann vermittelt werden, wie der aktuelle Zustand seiner Hochvoltbatterie ist und was ein Tausch des Moduls in Bezug auf die elektrische Reichweite verbessern könnte.

Leistung und Innenwiderstand

Weitere Ermittlungen der Lade- und Entladeleistung, sowie die Bestimmung des Innenwiderstandes, geben Aufschluss über die Leistungsfähigkeit des Akkumulators, da durch Alterung der Innenwiderstand steigt und somit eine erhöhte Verlustleistung innerhalb des Batteriemoduls auftritt.

Es ist von Vorteil, wenn die vorgegebenen Prüfbedingungen eingehalten werden. Da das Verfahren im Sommer und Winter durchführbar sein muss und das Fahrzeug nicht mechanisch oder elektrisch beschädigt werden darf, ist es essenziell, dass der Verbrennungsmotor, sowie auch die Hochvoltbatterie ihre Betriebstemperatur erreicht haben. Vor allem die Temperatur bei dem Akkumulator sollte im Arbeitsbereich liegen, um stets vergleichbare Ergebnisse erzielen zu können. Deshalb sind in den vorgegebenen Prüfbedingungen diese Temperaturgrenzen festgelegt.

Auch beim Ladezustand gibt es Grenzen, da der Akkumulator entladen werden muss und ein zu hoher Ladezustand den Entladeprozess unnötig lang verzögern würde. Diese Grenze soll allerdings auch als ein Mindestladezustand dienen, da mindestens 10 % der Kapazität entladen werden sollten, um eine genaue Aussagen über die errechnete Kapazität treffen zu können.

Ausführungsbeispiele

Bevorzugte Ausführungsbeispiele der Erfindung sind in der Zeichnung dargestellt und in der nachfolgenden Beschreibung näher erläutert.

Es zeigen:

Figur 1     ein Hybridfahrzeug mit einer Hochvoltbatterie in schematischer Darstellung,

Figur 2     ein Ablaufdiagramm zu einem Verfahren zur Bewertung des Gesundheitszustandes einer Hochvoltbatterie,

Figur 3     ein Ablaufdiagram eines statischen Prüfablaufes und

Figur 4     ein Ablaufdiagram eines dynamischen Prüfablaufes.

Ausführungsformen der Erfindung

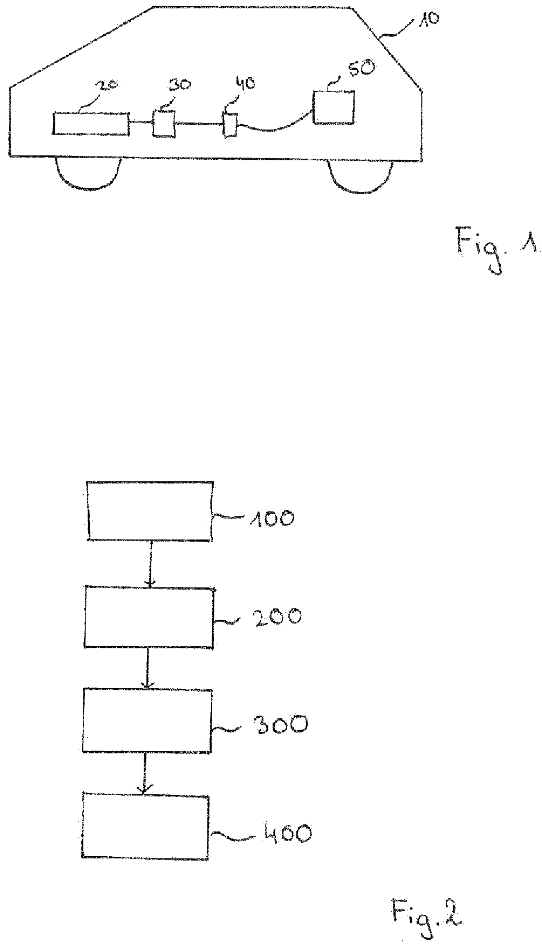

Die Figur 1 zeigt ein Hybridfahrzeug 10 mit einer Hochvoltbatterie 20 in schematischer Darstellung. Die Hochvoltbatterie 20 ist mit einem Batteriesteuergerät 30 verbunden. Das Batteriesteuergerät 30 ist über einen Fahrzeugbus mit einer OBD-Schnittstelle 40 verbunden. Um Daten und Parameter zur Bewertung der Hochvoltbatterie abzurufen, kann eine Verbindung zwischen einem Tester 50 und dem Batteriesteuergerät 30 aufgebaut werden. Diese Verbindung kann kabelgebunden sein, indem der Tester 50 an die OBD-Schnittstelle 40 des Fahrzeuges 10 angeschlossen wird.

In einer alternativen Ausführungsform kann die Verbindung zwischen dem Tester 50 und dem Batteriesteuergerät 30 auch kabellos aufgebaut werden, beispielsweise über Bluetooth, WLan oder andere Kanäle zur kabellosen Datenübertragung.

In der Figur 2 ist ein Ablaufdiagramm zu einem Verfahren zur Bewertung des Gesundheitszustandes einer Hochvoltbatterie 20 eines Hybridfahrzeugs 10 im eingebauten Zustand dargestellt.

Das Verfahren weist die folgenden Schritte auf:
In einem Verfahrensschritt 100 wird eine Verbindung zwischen dem Tester 50 und dem Batteriesteuergerät 30 aufgebaut. Wie bereits erläutert kann dieser Verbindungsaufbau kabelgebunden oder kabellos erfolgen.

In einem Verfahrensschritt 200 wird überprüft, ob die vorgegebenen Prüfbedingungen eingehalten wurden. Die Prüfbedingungen umfassen eine vorgegebene Kühlwassertemperatur, eine Hochvoltbatterietemperatur und einen Ladezustand der Hochvoltbatterie. Hierbei sollte die Kühlwassertemperatur größer gleich 50 °C sein, die Temperatur der Hochvoltbatterie 20 sollte zwischen 20 °C und 40°C liegen und der Ladezustand der Hochvoltbatterie 20 sollte zwischen 55% und 60% betragen.

In einem Verfahrensschritt 300 wird ein statischer Prüfablaufes 300 durchgeführt, wobei mindestens eine statische Batteriekenngröße ermittelt wird. Der statische Prüfablauf 300 wird am stehenden Fahrzeug 10 durchgeführt wird. Dabei ist wichtig, dass das Fahrzeug 10 während des statischen Prüfablauf 300 vor dem Wegrollen gesichert ist. Während des statischen Prüfablaufs 300 kann die Bremse dauerhaft betätigt werden, der Rückwärtsgang eingelegt werden und das Gaspedal aktiviert werden. Damit wird der Akkumulator im Stand mit einem geringen Strom entladen. Während diesem Prozess, wird eine Kapazitätsermittlung erfolgen und ständig die Differenzspannung sowie der Differenzinnenwiderstand, basierend auf den Daten des Batteriesteuergerätes 30, überwacht werden.

Während des statischen Prüfablaufs 300 sollte der Ladezustand der Hochvoltbatterie 20 um einen vorgegebenen Wert reduziert werden. Der vorgegebene Wert kann hierbei bevorzugt einer Reduzierung der Kapazität um 10% entsprechen, um eine genaue Aussage über die errechnete Kapazität zu treffen.

In einem Verfahrensschritt 400 wird ein dynamischer Prüfablaufs 400 durchgeführt, wobei mindestens eine dynamische Batteriekenngröße ermittelt wird. Beim dynamischen Prüfablauf 400 ist das Fahrprofil einer dynamischen Fahrt vorgesehen. Dabei sollen drei Beschleunigungen bis etwa 60 km/h aus dem Stand getätigt werden. Insgesamt soll die Messzeit ab dem Vollgasbefehl mindestens zwei Sekunden, bei optimalen Bedingungen drei Sekunden, betragen. Im dynamischen Prüfablauf 400 werden die Innenwiderstände der Zellblöcke der Hochvoltbatterie 20 als dynamische Batteriekenngröße berechnet.

Weitere Voraussetzung für den Ablauf des statischen und dynamischen Prüfablaufs sind eine Hochvoltbatterie 20, die einen Ladezustand zwischen 55% und 65% aufweisen muss, die Zündung muss eingeschaltet sein und der Verbrennungsmotor muss ausgeschaltet sein, da ansonsten die Messungen der Batteriekenngrößen durch die Energieabgabe des Verbrennungsmotors verfälscht wären.

In einem Verfahrensschritt 500 wir der Gesamt-Gesundheitszustandes der Hochvoltbatterie 20 aus mindestens einer statischen Batteriekenngröße und mindestens einer dynamischen Batteriekenngröße berechnet.

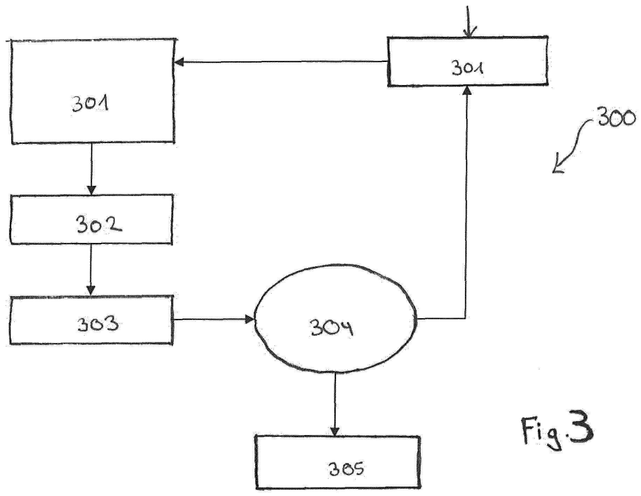

Die Figur 3 zeigt ein Ablaufdiagram des statischen Prüfablaufes 300. Der Schritt 301 besteht aus einem Counter (Schleifenzähler), der für nachfolgende Rechnungen unabdingbar ist. Es folgt im Schritt 302 eine Abfrage von Istwerten des Batteriesteuergerätes 30, dabei wird der Strom, die Min/Max Spannung des Batteriemoduls, der Ladezustand und die Motordrehzahl abgefragt. Im Schritt 302 wird der im Schritt 301 gemessene Stromwert aufaddiert. Im Schritt 303 wird die im Schritt 301 gemessene Differenzspannung zwischen der minimalen und maximalen Spannung aufaddiert.

Im Schritt 304 wird überprüft, ob der Entladeprozess beendet werden muss, weil beispielsweise ein Ladezustand von 40 % SOC (SOC=State of Charge) erreicht wurde, oder der Verbrennungsmotor gestartet hat. Falls dies nicht der Fall ist, wird erneut zum Schritt 301 gegangen und der Schrittzähler um den Wert 1 erhöht.

Im Schritt 305 werden die aufaddierten Werte des Stroms I und der Differenzspannung U durch den Wert des Counters n geteilt um einen Mittelwert des Stromes und der Differenzspannung zu erhalten. Des Weiteren erfolgt eine Berechnung von mindestens einer statischen Batteriekenngröße.

Die erste statische Batteriekenngröße SOHc ist ein State-of Health-Wert (SOH-Wert), welcher sich auf die Kapazität bezieht und wird wie folgt berechnet:

$$Ladung\ [Ah] = \sum_{0}^{n} \left(\frac{Strom\ [A]}{n}\right) \times Messzeit[h]$$

$$Differenz\ SOC = Start\ SOC - End\ SOC$$

$$Kapazität\ [Ah] = \left(\frac{Ladung\ [Ah]}{Differenz\ SOC}\right) \times 100$$

$$SOHc \; [\%] = \left( \frac{Kapazit\ddot{a}t \; gealterte \; Bat. \, [Ah]}{Kapazit\ddot{a}t \; neue \; Bat. \, [Ah]} \right) \times 100$$

Hierbei entspricht Strom [A] den im Schritt 302 aufaddierten Werten des Stromes, n ist der Wert des Counters. Start SOC entspricht dem Ladezustand beim Start der Messung, End SOC dem Ladezustand am Ende der Messung,
**[0035]** Die zweite statische Batteriekenngröße SOHr_1 ist ein State-of Health-Wert, welcher sich auf den Differenzinnenwiderstand bezieht:

$$SOHr_1 \; [\%] = -10000 \times \text{Differenzinnenwiderstand} \; [\Omega] + 100$$

Die dritte statische Batteriekenngröße SOHv ist ein State-of Health-Wert, welcher sich auf die Differenzspannungen bezieht:

$$SOHv \; [\%] = -100 \times \text{DifferenzSpannung} \; [V] + 120$$

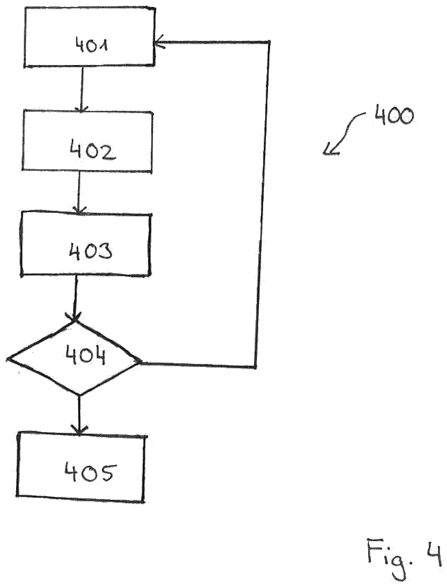

Die Figur 4 zeigt ein Ablaufdiagram des dynamischen Prüfablaufes 400. Der dynamische Prüfablauf 400 ist so aufgebaut, dass vor jeder Beschleunigung im Schritt 401 eine Abfrage gestartet wird, ob der Wagen stillsteht und der Verbrennungsmotor ausgeschaltet ist. Nachdem dies erfolgt, wird im Schritt 402 eine Messung der Spannungen aller Zellböcke durchgeführt und bei jedem der nachfolgenden Schleifendurchgänge aufaddiert, um später einen Mittelwert der Spannung im unbelasteten Zustand zu bekommen. Des Weiteren wird Strom I bei Beginn der Beschleunigungsphase gemessen.
Nachdem die Spannungen des unbelasteten Zustandes aufgenommen wurden, wird der Wagen im Schritt 403 durch eine Betätigung des Fahrpedals voll beschleunigt und dieser Vorgang für mindestens 2 Sekunden, bei optimalen Bedingungen für 3 Sekunden, gehalten. Nach einer vorgegebenen Zeitspanne, welche mindestens 2 Sekunden nach dem Start der Fahrt liegt, erfolgt im Schritt 404 eine erneute Messung der einzelnen Zellblock-Spannungen, sowie des Stromes. Auch diese Spannungen und der Stromwert, werden mit jedem Durchlauf addiert, um später einen Mittelwert der Zellblock-Spannungen und des Stromes im belasteten Zustand zu bekommen.
Im Schritt 404 wird überprüft, ob ein Counter (Schrittzähler), welcher mit dem Wert n=0 beginnt und bei jedem Durchgang um den Wert 1 erhöht wird, einen Wert von drei erreicht hat. Falls dies nicht der Fall ist, wird erneut zum Schritt 401 gegangen. Ansonsten erfolgt im Schritt 405 eine Berechnung der Mittelwerte der Spannungen OCV "Open Circuit Voltage" unmittelbar vor der Beschleunigungsphase, der Spannungen $U_{3sec}$ 2 bzw. 3 Sekunden nach dem Start der Beschleunigungsphase und der Mittelwert der Stromdifferenz I vor und 2 bzw. 3 Sekunden nach der Belastung.

$$R_i = \frac{OCV - U_{3sec}}{I}$$

Aus dem Mittelwert des Stroms I und dem Mittelwert U (OCV-$U_{3sec}$) wird ein Innenwiderstand der gealterten Batterie $R_i$= U/I berechnet, welcher zur Ermittlung der dynamische Batteriekenngröße $SOHr_2$ dient.

$$SOHr_2[\%] = \frac{100}{Ri} * \text{Ri}_{neu}[\Omega]$$

Hierbei ist $Ri_{neu}$ der Innenwiderstand einer neuen Hochvoltbatterie 20, welcher aus dem Herstellerdatenblatt ersichtlich, oder Experimentell ermittelt werden kann.
Der Gesamt-Gesundheitszustand kann durch einen gewichteten Mittelwert aus SOHc, SOHv, $SOH_{r1}$ und $SOH_{r2}$ gebildet wird, wobei die einzelnen Batteriekenngrößen durch die Faktoren a, b, c, d unterschiedlich gewichtet werden:

$$SOH_{ges} \; [\%]= (a* \; SOH_C+b*SOH_{r1}+c*SOH_{r2}+d*SOH_V)/(a+b+c+d)$$

Da die Kapazität und die Differenzspannung einfach und präzise zu ermitteln sind, werden die Batteriekenngrößen, die sich auf diese Messwerte beziehen höher gewichtet, als die anderen Batteriekenngrößen. Aus diesem Grund ist eine bevorzugte Berechnung des Gesamt-Gesundheitszustandes $SOH_{ges}$ der Batterie in der folgenden Formel be-

schrieben:

$$SOH_{ges}[\%] = ((SOHc * 3) + (SOH_{r1} * 2) + SOHr_2 + (SOHv * 4))/10$$

**Patentansprüche**

1. Verfahren zur Bewertung des Gesundheitszustandes einer Hochvoltbatterie (20) eines Hybridfahrzeugs (10) im eingebauten Zustand, mit den Schritten:

   - Aufbau einer Verbindung zwischen einem Tester (50) und einem Batteriesteuergerät (30),
   - Überprüfung, ob vorgegebene Prüfbedingungen (200) eingehalten sind,
   - Durchführen eines statischen Prüfablaufes (300), wobei mindestens eine statische Batteriekenngröße ermittelt wird,
   - Durchführen eines dynamischen Prüfablaufes (400), wobei mindestens eine dynamische Batteriekenngröße ermittelt wird, und
   - Berechnung des Gesamt-Gesundheitszustandes der Hochvoltbatterie (20) aus der mindestens einen statischen Batteriekenngröße und der mindestens einen dynamischen Batteriekenngröße,

   **dadurch gekennzeichnet,**
   **dass** für den Ablauf des statischen Prüfablaufs (300) das Fahrzeug (10) durch die Betätigung einer Bremse dauerhaft vor einem Wegrollen gesichert ist, während das Fahrpedal leicht betätigt wird bis sich der Ladezustand der Hochvoltbatterie (20) um einen vorgegebenen Wert reduziert hat oder bis der Verbrennungsmotor startet,
   **dass** während des statischen Prüfablaufs (300) aus der Kapazität der gealterten Batterie (20) ein $SOH_C$ und aus der maximalen und minimalen Zellspannungsdifferenz ein $SOH_V$ und dem minimalen und maximalen Zellinnenwiderstand ein $SOH_{r1}$ ermittelt wird,
   **dass** für den dynamischen Prüfvorgang (400) folgender Prüfablauf mindestens 3 Mal durchgeführt wird:

   ◦ Fahrzeug (10) steht bei ausgeschalteten Verbrennungsmotor,
   ◦ Beschleunigen des Fahrzeuges (10) durch Betätigung des Fahrpedals für mindestens 3 Sekunden bis zum Endanschlag,

   **dass** während des dynamischen Prüfablaufs (400) aus dem Strom I bei Beginn der Beschleunigungsphase und aus der Spannung U nach einer vorgegebenen Zeitspanne, welche mindestens 2 Sekunden, unter optimalen Bedingungen 3 Sekunden, nach dem Beginn der Beschleunigungsphase gemessen wird, ein Innenwiderstand der gealterten Batterie $R_i$ berechnet wird, welcher zur Ermittlung einer dynamischen Batteriekenngröße $SOH_{r2}$ dient,
   **dass** als Voraussetzung für den Ablauf des statischen und dynamischen Prüfablaufs (300,400) die Hochvoltbatterie (20) einen Ladezustand zwischen 55% und 65% aufweisen muss, die Zündung eingeschaltet sein muss und der Verbrennungsmotor ausgeschaltet sein muss,
   und **dass** die Berechnung des Gesamt-Gesundheitszustandes der Hochvoltbatterie $SOH_{ges}$ durch einen Mittelwert aus $SOH_C$, $SOH_V$, $SOH_{r1}$ und $SOH_{r2}$ erfolgt, wobei die einzelnen Werte durch Faktoren a, b, c, d unterschiedlich gewichtet werden:

   $$SOH_{ges} [\%]= (a* SOH_C+b*SOH_{r1}+c*SOH_{r2}+d*SOH_V)/(a+b+c+d).$$

2. Verfahren nach Anspruch 1, wobei der statische Prüfablauf (300) bei einem stehenden Fahrzeug durchgeführt wird und der dynamische Prüfablauf (400) bei einem bewegten Fahrzeug durchgeführt wird.

3. Verfahren nach Anspruch 1, wobei die vorgegebenen Prüfbedingungen eine vorgegebene Kühlwassertemperatur, eine Hochvoltbatterietemperatur und einen Ladezustand der Hochvoltbatterie (20) umfassen.

4. Batterietester (50) zur Bewertung des Gesundheitszustandes einer Hochvoltbatterie (20) eines Hybridfahrzeugs (10) im eingebauten Zustand, welcher eine Verbindung zum Batteriesteuergerät (30) des Fahrzeuges (10) aufbaut, **dadurch gekennzeichnet, dass** der Batterietester (50) dazu eingerichtet ist, ein Verfahren nach einem der Ansprüche 1 bis 3 durchzuführen.

**Claims**

1. Method for evaluating the state of health of a high-voltage battery (20) of a hybrid vehicle (10) in the installed state, comprising the steps of:

   - establishing a connection between a tester (50) and a battery control device (30),
   - checking whether specified test conditions (200) are complied with,
   - carrying out a static test procedure (300), wherein at least one static battery characteristic variable is determined,
   - carrying out a dynamic test procedure (400), wherein at least one dynamic battery characteristic variable is determined, and
   - calculating the overall state of health of the high-voltage battery (20) from the at least one static battery characteristic variable and the at least one dynamic battery characteristic variable,

   **characterized**
   **in that**, for the execution of the static test procedure (300), the vehicle (10) is permanently secured against rolling away by operating a brake, while the accelerator pedal is lightly operated until the state of charge of the high-voltage battery (20) has reduced by a specified value or until the internal combustion engine starts,
   **in that**, during the static test procedure (300), an $SOH_C$ is determined from the capacity of the aged battery (20) and an $SOH_V$ is determined from the maximum and minimum cell voltage difference and an $SOH_{r1}$ is determined from the minimum and maximum cell internal resistance,
   **in that**, for the dynamic test process (400), the following test procedure is carried out at least 3 times:

   ◦ vehicle (10) is stationary with the internal combustion engine turned off,
   ◦ acceleration of the vehicle (10) by operating the accelerator pedal as far as the end stop for at least 3 seconds,

   **in that**, during the dynamic test procedure (400), an internal resistance of the aged battery $R_i$ is calculated from the current I at the beginning of the acceleration phase and from the voltage U after a specified time period which is measured at least 2 seconds, under optimal conditions 3 seconds, after the beginning of the acceleration phase, said internal resistance serving to determine a dynamic battery characteristic variable $SOH_{r2}$,
   **in that**, as a prerequisite for the execution of the static and the dynamic test procedure (300, 400), the high-voltage battery (20) has to have a state of charge of between 55% or 65%, the ignition has to be turned on and the internal combustion engine has to be turned off, and in that the overall state of health of the high-voltage battery $SOH_{overall}$ is calculated using a mean value of $SOH_C$, $SOH_V$, $SOH_{r1}$ and $SOH_{r2}$, with the individual values being weighted differently by factors a, b, c, d:

$$SOH_{overall} \ [\%] = (a*SOH_C + b*SOH_{r1} + c*SOH_{r2} + d*SOH_V) / (a+b+c+d).$$

2. Method according to Claim 1, wherein the static test procedure (300) is carried out when a vehicle is stationary and the dynamic test procedure (400) is carried out when a vehicle is moving.

3. Method according to Claim 1, wherein the specified test conditions comprise a specified cooling water temperature, a high-voltage battery temperature and a state of charge of the high-voltage battery (20).

4. Battery tester (50) for evaluating the state of health of a high-voltage battery (20) of a hybrid vehicle (10) in the installed state, which battery tester establishes a connection to the battery control device (30) of the vehicle (10), **characterized in that** the battery tester (50) is designed to carry out a method according to one of Claims 1 to 3.

**Revendications**

1. Procédé pour évaluer l'état de santé d'une batterie à haute tension (20) d'un véhicule hybride (10) à l'état installé, comprenant les étapes :

- établissement d'une connexion entre un testeur (50) et un contrôleur de batterie (30),
- vérification si des conditions d'essai (200) prédéfinies sont respectées,
- réalisation d'une séquence d'essai statique (300), au moins une grandeur caractéristique statique de la batterie étant déterminée,
- réalisation d'une séquence d'essai dynamique (400), au moins une grandeur caractéristique dynamique de la batterie étant déterminée, et
- calcul de l'état de santé total de la batterie à haute tension (20) à partir de l'au moins une grandeur caractéristique statique et de l'au moins une grandeur caractéristique dynamique,

**caractérisé en ce**
**que** pour le déroulement de la séquence d'essai statique (300), le véhicule (10) est continuellement bloqué pour l'empêcher de rouler en actionnant un frein, alors que la pédale d'accélérateur est légèrement actionnée jusqu'à ce que l'état de charge de la batterie à haute tension (20) se soit réduit d'une valeur prédéfinie ou jusqu'à ce que le moteur à combustion interne démarre,
**que** pendant la séquence d'essai statique (300), sont déterminés un $SOH_C$ à partir de la capacité de la batterie (20) vieillie et un $SOH_V$ à partir de la différence de tension de cellule maximale et minimale et un $SOH_{r1}$ à partir de la résistance interne de cellule minimale et maximale,
**que** la séquence d'essai suivante est exécutée au moins 3 fois pour la séquence d'essai dynamique (400) :

○ le véhicule (10) est à l'arrêt avec le moteur à combustion interne éteint,
○ accélération du véhicule (10) en actionnant la pédale d'accélérateur pendant au moins 3 secondes jusqu'à la butée finale,

**que** pendant la séquence d'essai dynamique (400), une résistance interne de la batterie $R_i$ vieillie, laquelle sert à déterminer une grandeur caractéristique dynamique de la batterie $SOH_{r2}$, est calculée à partir du courant I au début de la phase d'accélération et à partir de la tension U après un intervalle de temps prédéfini, laquelle est mesurée au moins 2 secondes, dans des conditions optimales 3 secondes après le début de la phase d'accélération,
**qu'**en tant que condition pour le déroulement de la séquence d'essai statique et dynamique (300, 400), la batterie à haute tension (20) doit présenter un état de charge entre 55 % et 65 %, le contact doit être mis et le moteur à combustion interne doit être éteint,
et **que** le calcul de l'état de santé total de la batterie à haute tension $SOH_{ges}$ s'effectue par une moyenne de $SOH_C$, $SOH_V$, $SOH_{r1}$ et $SOH_{r2}$, les valeurs individuelles étant pondérées différemment par des facteurs a, b, c, d :

$$SOH_{ges} \ [\%] = (a*SOH_C + b*SOH_{r1} + c*SOH_{r2} + d*SOH_V)/(a+b+c+d).$$

2. Procédé selon la revendication 1, la séquence d'essai statique (300) étant effectuée avec un véhicule à l'arrêt et la séquence d'essai dynamique (400) étant effectuée avec un véhicule en mouvement.

3. Procédé selon la revendication 1, les conditions d'essai prédéfinies comprenant une température d'eau de refroidissement prédéfinie, une température de batterie à haute tension et un état de charge de la batterie à haute tension (20).

4. Testeur de batterie (50) destiné à évaluer l'état de santé d'une batterie à haute tension (20) d'un véhicule hybride (10) à l'état installé, lequel établit une connexion au contrôleur de batterie (30) du véhicule (10), **caractérisé en ce que** le testeur de batterie (50) est conçu pour mettre en œuvre un procédé selon l'une quelconque des revendications 1 à 3.

Fig. 1

Fig. 2

Fig.3

Fig. 4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014217135 A1
- CN 105015360 B
- CN 107132484 A
- CN 106526486 B
- US 10005372 B2
- US 2018188332 A1
- WO 2015101570 A1
- CN 102760914 B
- EP 3246215 A1